# EUROPEAN PATENT APPLICATION

(11) **EP 1 696 129 A2**
(43) Date of publication of application: **30.08.2006**
(21) Application number: 05107486.2
(22) Date of filing: 15.08.2005
(51) Int. Cl.: F04D 13/02, H01L 23/473

(54) **Liquid-Cooled heat dissipation module**

(30) Priority: 28.02.2005 CN 200510525123
(71) Applicant: Delta Electronics, Inc., Taoyuan Hsien 333 (TW)
(72) Inventor: Chen, Lee-Long, 333, Taoyuan Hsien (TW); Huang, Chien-Hsiung, 333, Taoyuan Hsien (TW); Huang, Shih-Ming, 333, Taoyuan Hsien (TW); Huang, Wen-Shi, 333, Taoyuan Hsien (TW)
(74) Representative: Patentanwälte Kewitz & Kollegen

(57) **Abstract**

A liquid-cooled heat dissipation module for circularly dissipating heat from a heat source. The liquid-cooled heat dissipation module includes a base, a rotor supported by the base and having a hub, a first magnetic part, and a pump having a second magnetic part and a fixed seat. The fixed seat is coupled to the base and has a space to receive the second magnetic part. When the first magnetic part is rotating along with the rotor, the second magnetic part is driven by a magnetic interaction between the first and second magnetic parts so as to generate a circular flow of the working fluid in the pump.

## Description

### BACKGROUND

The invention relates to a liquid-cooled heat dissipation module, and in particular to a liquid-cooled heat dissipation module integrally formed by a fan and a pump.

With the evolution of CPU or electronic component placement techniques, high performance and efficient data calculation can be obtained. A large amount of heat, however, is continuously generated due to high-frequency oscillation or electromagnetic effects generated by operation of the CPU or electronic components. Inefficient heat dissipation leads to CPU or electronic component breakdown and burnout. In general, a heat sink is disposed on a heat source, and a fan or impeller is used to dissipate heat from the heat sink.

Heat from a CPU of a high-level system, however, cannot be efficiently dissipated by an air cooling system, and requires a water-cooling system or similar. A pump is required to circulate low-temperature and high-temperature water in the system.

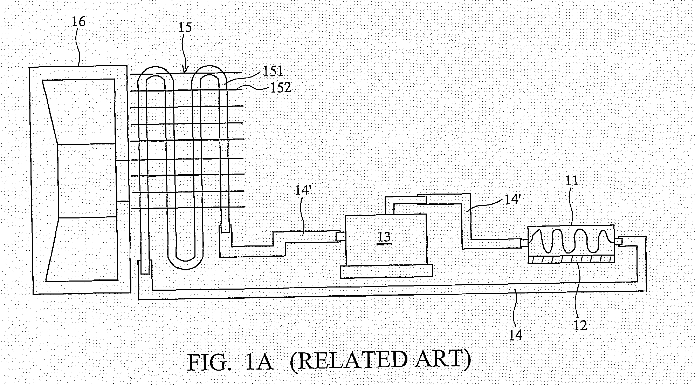

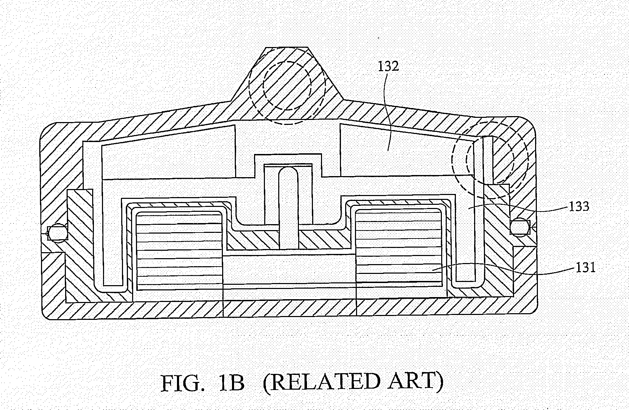

In Fig. 1, a conventional water-cooled heat dissipation system designed for a CPU 12 of a high-level system includes a copper seat 11, a pump 13, two conduits 14/14', a heat sink 15 comprising a heat pipe 151 and a plurality of fins 152, and a fan 16. The bottom of the copper seat 11 is attached to the CPU 12 to absorb heat generated from CPU 12. The water of low temperature in the conduit 14 is transmitted to an S-shaped passage of the copper seat 11 by the pump 13, inflows into a right-side inlet and outflows from a left-side outlet of the copper seat 11 to absorb heat from the CPU 12. The heated water in the conduit 14' is transmitted to a heat pipe 151 of the heat sink 15 by the pump 13, and a plurality of fins 152 absorb heat from the heated water in the conduit 14'. The fan 16 blows the fins 152 to dissipate heat thereon to the exterior, to reduce the temperature of the water in the conduit 14'. Thus, the cooled water in the conduit 14' circulates to the copper seat 11 to absorb heat from the copper seat 11 again.

The fan 16 and the pump 13 of the above-described water-cooled heat dissipation system are respectively actuated by a motor. In Fig. 1B, a motor for driving the pump 13 includes a silicon-steel stator 131 and a magnetic ring 132. The silicon-steel stator 131 and the magnetic ring 132 are conventionally separated by a waterproofing method to form a plastic layer 133 and a safe-rotation clearance therebetween.

The conventional water-cooled system has several drawbacks including: increased clearance between the rotor and stator; reduced torque; difficulties in installation of the water and exhaust gas; complicated assembly requiring many components; and the large space and volume requirements. Thus, assembly of the water-cooled system is time-consuming and costly.

### SUMMARY

The invention provides a liquid-cooled heat dissipation module integrally including a fan and a pump actuated by a single motor, to reduce cost and volume and simplify the structure.

A liquid-cooled heat dissipation module includes: a base; a rotor supported by the base and having a hub; a first magnetic part disposed on a top of the hub; and a pump comprising a second magnetic part and a fixed seat, wherein the fixed seat coupled to the base includes a space for receiving the second magnetic part. When the first magnetic part rotates along with the rotor, a magnetic force is generated between the first and second magnetic parts to rotate the second magnetic part, thereby circulating the working fluid in the pump.

Preferably, the rotor further includes a metallic housing, and the first magnetic part is disposed in a space between an inner top surface of the hub and a top surface of the metallic housing.

Preferably, the rotor further includes a metallic housing, and the top of hub has an opening to receive the first magnetic part supported by the metallic housing.

The liquid-cooled heat dissipation module further includes a frame to receive the base and the rotor therein. The fixed seat is connected to the frame by locking, engaging, riveting, adhesion or ultrasonic fusion.

The pump further includes a cover connected to the fixed seat to form a space therebetween, and the second magnetic part is disposed in the space between the cover and the fixed seat. An O-ring is disposed at an intersection between the chassis and the cover.

The pump further includes a central hole to receive a bearing and a wearing piece, and a shaft of the pump supported by the bearing is fixed on the fixed seat. The bearing and the shaft of the pump is made of ceramic material. The second magnetic part includes a guide blade and a magnetic ring and the pump further has an inlet and an outlet, so that the working fluid inflowing through the inlet passes through the outlet when the guide blade and the magnetic ring are rotated with respect to the shaft of the pump. The guide blade has a radially straight structure or a curved structure.

The second magnetic part further includes a magnetic body and a plastic material covering the magnetic body to form a plastic-covered magnetic body. The second magnetic part has a plastic-magnet mixture integrally formed by injection molding.

A clearance is formed between the first magnetic part and the second magnetic part, and an axially or radially magnetic attraction force generated between the first magnetic part and the second magnetic part actuates the pump. An axially or radially magnetic attraction force is generated between the first magnetic part and the second magnetic part. The first magnetic part and the second magnetic part respectively includes a magnet-charging area having a pole number greater than two. The magnet-charging area of the first magnetic part corresponds to the magnet-charging area of the second magnetic part, and a staggered angle is formed between the magnet-charging area of the first magnetic part and the magnet-charging area of the second magnetic part.

The liquid-cooled heat dissipation module further includes a heat sink circumferentially disposed around the pump and comprising a central hole 81 for receiving the pump therein. The fixed seat is fixed on the heat sink.

The liquid-cooled heat dissipation module further includes a conductive seat attached to a heat source fro conducting heat generated by the heat source to the pump. The conductive seat comprises a chassis, a cover and a passage, wherein the passage includes a concentrically vortex structure or an inside-outwardly extending spiral structure. The passage on the chassis is formed by milling. The cover covering the chassis and the passage is integrally formed by injection molding. An 0-ring is disposed at an intersection between the chassis and the cover.

Preferably, the rotor includes a motor, DC fan, or AC fan.

The invention provides another liquid-cooled heat dissipation module, including a base, a rotor supported by the base, comprising a shaft extending outwardly from the base at one end thereof, a first magnetic part disposed on an extruded portion of the shaft, and a pump including a second magnetic part and a fixed seat coupled to the base to form a first space to receive the first magnetic part. When the first magnetic part rotates with respect to the rotor, a magnetic force is generated between the first and second magnetic parts to rotate the second magnetic part, thereby circulating the working fluid in the pump.

The first magnetic part includes a magnet-conductive iron sheet and a magnetic ring attached to the magnet-conductive iron sheet. The liquid-cooled heat dissipation module further includes a copper sleeve for installing the magnet-conductive iron sheet and the magnetic ring on the shaft. Thus, the magnet-conductive iron sheet and the magnetic ring and the copper sleeve are synchronically rotated by the shaft.

The pump further includes a cover connected to the fixed seat to form a second space to receive the second magnetic part.

Preferably, a clearance is formed between the first magnetic part and the second magnetic part, and an axially or radially magnetic attraction force generated between the first magnetic part and the second magnetic part actuates the pump.

The invention provides another liquid-cooled heat dissipation module. This liquid-cooled heat dissipation module includes: a base having a recess; a rotor supported by the base including a first magnetic part; and a pump including a second magnetic part disposed in the recess. When the first magnetic part of the rotor rotates, a magnetic force is generated between the first and second magnetic parts to rotate the second magnetic part, circulating the working fluid in the pump. Preferably, an axially or radially magnetic attraction force is generated between the first magnetic part and the second magnetic part.

### BRIEF DESCRIPTION OF THE DRAWINGS

The invention can be more fully understood by reading the subsequent detailed description and examples with references made to the accompanying drawings, wherein:
Fig. 1A is a schematic diagram of a conventional water-cooled heat dissipation system for a CPU of a high-level system.
Fig. 1B is a sectional view of a pump of the water-cooled heat dissipation system of Fig. 1A.
Fig. 2A is a schematic sectional view of the first embodiment of a liquid-cooled heat dissipation module of the invention.
Fig. 2B is a schematic plan view of the distribution of the magnet-charging area of a first magnetic ring and a second magnetic ring of Fig. 2A.
Fig. 3A is a schematic sectional view of the second embodiment of a liquid-cooled heat dissipation module of the invention.
Fig. 3B is a schematic plan view of the distribution of the magnet-charging area of a first magnetic ring and a second magnetic ring of Fig. 3A.
Fig. 4 is a schematic sectional view of the third embodiment of a liquid-cooled heat dissipation module of the invention.
Fig. 5 is a schematic sectional view of the fourth embodiment of a liquid-cooled heat dissipation module of the invention.
Fig. 6 is a schematic sectional view of the fifth embodiment of a liquid-cooled heat dissipation module of the invention.
Fig. 7 is a top view of a pump of the invention.
Fig. 8 is a schematic view of a liquid-cooled heat dissipation module of the invention for a CPU of a high-level system.
Fig. 9A is a schematic sectional view of a conductive seat of Fig. 8.
Fig. 9B is a top view of a passage of the conductive seat of Fig. 8.

### DETAILED DESCRIPTION

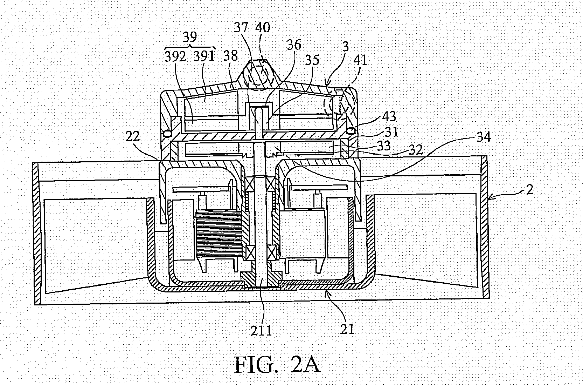

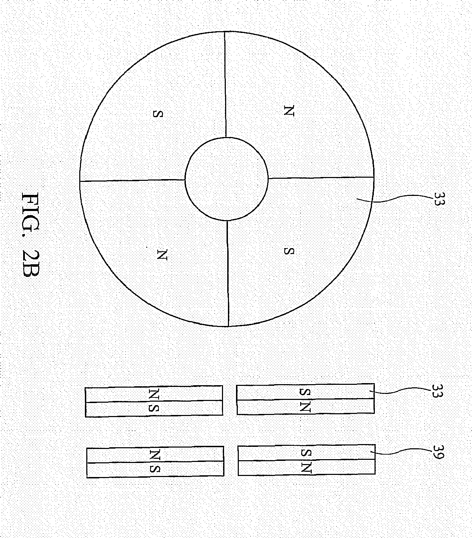

In Fig. 2A, a liquid-cooled heat dissipation module of the first embodiment of the invention includes a fan 2 and a pump 3. The fan 2 includes a rotor 21 having a shaft 211, and a base 22 used to support the rotor 21 The shaft 211 of the rotor 21 extends outwardly from the bottom of the base 22 at one end thereof. Preferably, the rotor 21 can be a motor, DC fan, or AC fan.

The pump 3 includes a fixed seat 31, a first magnetic part 33 comprising a magnet-conductive iron sheet 32 and a magnetic ring 33 attached to the magnet-conductive iron sheet 32, a copper sleeve 34, a bearing 35, a wearing piece 36, a shaft 37, a plastic cover 38, and a second magnetic part 39 having a guide blade 391 and a magnetic ring 392. The bearing 35 and the shaft 37 of the pump 3 is preferably made of ceramic material. The second magnetic part 39 is spaced from the first magnetic part 33 with a clearance.

The fixed seat 31 attached to the bottom of the base 22 is disposed on an inlet or an outlet of the fan 2. The fixed seat 31 is connected to the frame 26 by screwing, locking, engaging, riveting, adhesion, ultrasonic fusion, or the other methods. A first space formed between one side of the fixed seat 31 and the base 22 is used to receive the first magnetic part 33 therein. The magnet-conductive iron sheet 32 and the magnetic ring 33 are installed on the shaft 211 by the copper sleeve 34 so that the magnet-conductive iron sheet 32 and the magnetic ring 33 and the copper sleeve 34 are synchronically rotated by the shaft 211.

A central hole 81 located inside of the pump 3 receives the bearing 35 and the wearing piece 36, and a shaft 37 of the pump 3 supported by the bearing 35 is fixed on an opposite side of the fixed seat 31. The cover 38 of the pump 3 connected to the fixed seat 31 by screwing, locking, engaging, riveting, adhesion or ultrasonic fusion, to form a second space therebetween to receive the second magnetic part 39 therein. A working fluid, such as water, inflows into an inlet 40 of the pump 3 and outflows from an outlet 41 of the pump 3. An 0-ring 43 is disposed at an intersection between the cover 38 and the fixed seat 31, preventing leakage of the working fluid.

It should be noted that the fan 2 and the pump 3 of this embodiment are actuated by a single motor to reduce cost and simplify the structure. In Fig. 2B, when the motor is actuated, a common power transmitted to the first magnetic part 33 via the shaft 211 to synchronously drive the guide blade 391 of the pump 3 to rotate through an axially or radially magnetic attraction force between the first magnetic part 33 and the second magnetic part 39, thereby continuously circulating the working fluid. In this embodiment, the axially or radially magnetic attraction force is generated between the first magnetic part 33 and the second magnetic part 39, and the first magnetic part 33 and the second magnetic part 39 respectively functions as a magnet-charging area having a pole number greater than two. Thus, the magnet-conductive iron sheet 32 and the magnetic ring 33 of the first magnetic part 33 and the second magnetic part 39 can be divided into four magnet-charging areas.

By aligning the magnet-charging area (N polarization) of the magnetic ring 33 of the first magnetic part 33 to the magnet-charging area (S polarization) of the second magnetic part 39, a staggered angle is formed between the magnet-charging area of the first magnetic part 33 and the magnet-charging area of the second magnetic part 39 to rotate the second magnetic part 39 with respect to the first magnetic part 33 and to rotate the guide blade 391.

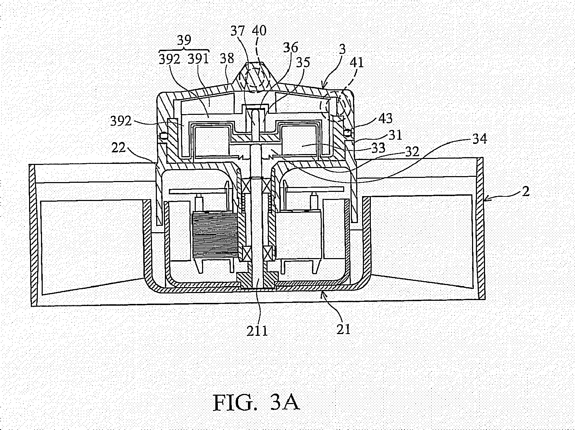

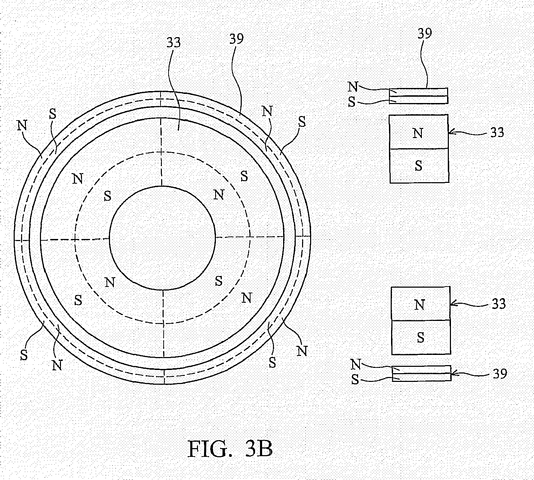

Additionally, an axially or radially magnetic attraction force can be formed between the first magnetic part 33 and the second magnetic part 39. In Fig. 3A, a liquid-cooled heat dissipation module of the second embodiment differs from the first embodiment in that the magnet-conductive iron sheet 32 and the magnetic ring 33 of the first magnetic part 33 and the second magnetic part 39 are radially distributed, the first magnetic part 33 has an outer diameter smaller than that of the second magnetic part 39, and the second magnetic part 39 is disposed on the outside of the first magnetic part 33. Fig. 3B shows the distribution of the magnetic areas of the magnetic ring 33 and the second magnetic part 39.

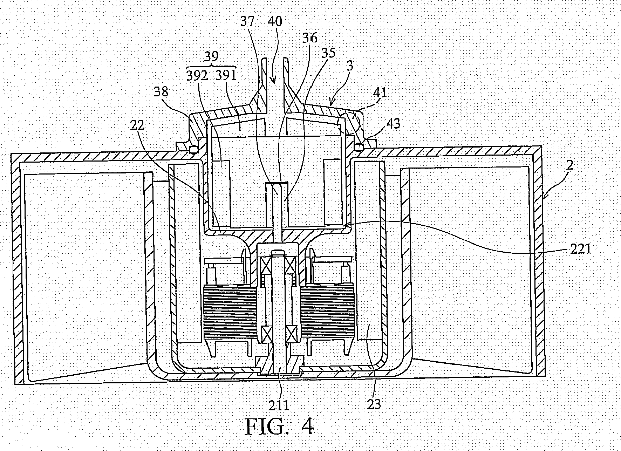

In Fig. 4, a liquid-cooled heat dissipation module of the third embodiment differs from the first and second embodiments in that the first magnetic part 33 is omitted, the base 22 further includes a recess 221 inwardly formed on the fan 2 to receive the second magnetic part 39 of the pump 3 therein, and a magnetic ring 23 of the motor inside the fan 2 elongates to be radially arranged with respect to the magnetic ring 392 to generate a radially magnetic force. Not only can the magnetic ring 23 interact with the silicon-steel stators and coils to drive the fan 2 to rotate but interact with the second magnetic part 39 to rotate the guide blade 391 of the pump 3 through the radially magnetic force generated therebetween.

Although the pump 3 in the above-described embodiments is disposed at the bottom (where an inlet is presumed to be) of the base 22, it can be disposed at the other side (where an outlet is presumed to be) of the fan 2, i.e., opposite to the bottom of the base 22.

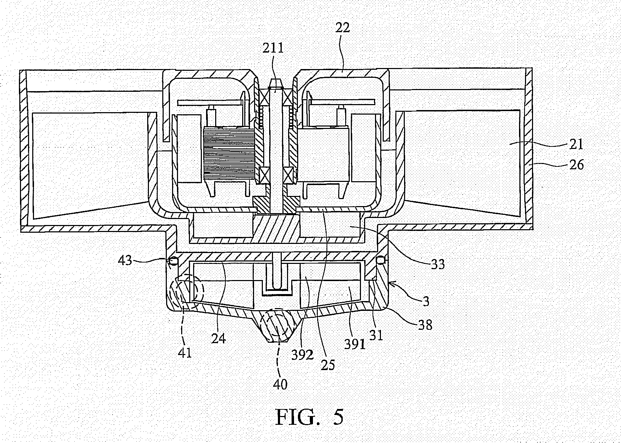

In Fig. 5, the fourth embodiment differs from the above-described embodiments in that the first magnetic part 33 is disposed in a space between an inner top surface of the hub 24 and a top surface of the metallic housing 25; the fixed seat 31 of the pump 3 disposed on the outlet of the frame 26 of the fan 2 is securely locked on the frame 26 of the fan 2, or the fixed seat 31 of the pump 3 can be fixed on the associated heat sink; the second magnetic part 39 is disposed in a concavity defined by the fixed seat 31 and the cover 38. Other structures are identical to those of the above-described embodiments, so the detailed descriptions are omitted. When the first magnetic part 33 is rotated along with the shaft 211, the second magnetic part 39 is synchronously rotated by the axially or radially magnetic attraction force generated between the first and second magnetic parts 33 and 39 so that the working fluid in the pump 3 can be continuously circulated to dissipate heat.

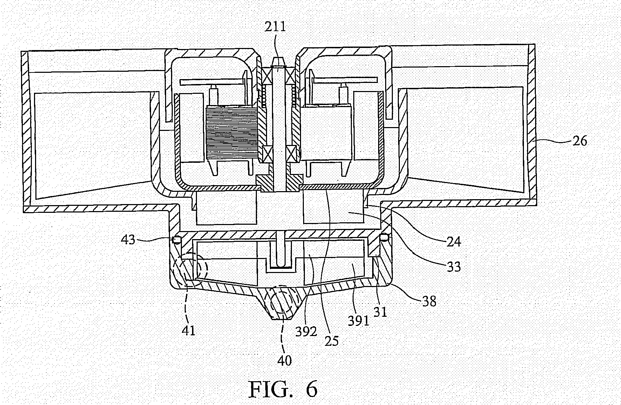

In Fig. 6, the fifth embodiment differs from the fourth embodiment in that an opening is formed on a top the hub 24 to receive the first magnetic part 33 therein to be supported by the metallic housing 25.

In all above-described embodiments, the guide blade 391 and the magnetic ring 392 can be individually manufactured and then assembled to form the second magnetic part 39. Alternatively, the second magnetic part 39 can be a magnetic body covered with a plastic material to form a plastic-covered magnetic body, or the second magnetic part 39 can be a plastic-magnet mixture integrally formed by injection molding.

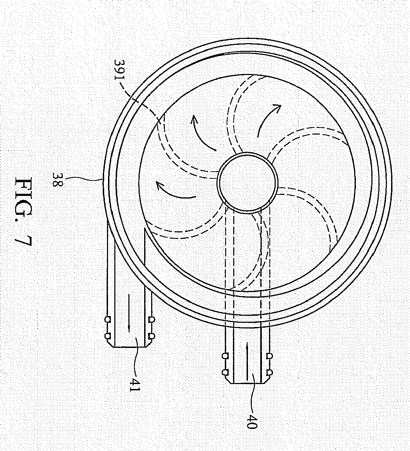

The guide blade 391 can be formed as a radially straight shape, or a curved shape in Fig. 7. When the working fluid inflows into the inlet 40 of the pump 3, the working fluid is centrifugally transmitted to the periphery and collectively output from an outlet 41 of the pump 3.

In the actual application, the liquid-cooled heat dissipation module of the above-described embodiments can be adopted to be use with a heat sink and a conductive seat attached to a heat source to conduct heat generated from the heat source to the pump.

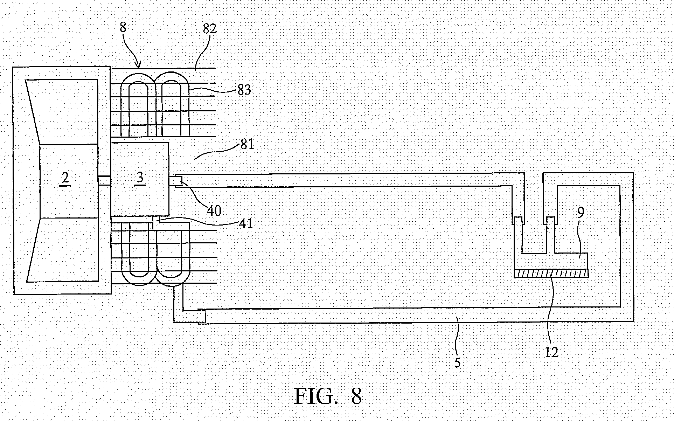

As shown in Fig. 8, the heat sink 8 includes a central hole 81, a plurality of fins 82 and a heat pipe 83 disposed between the fins 82. The central hole 81 receives the pump 3 therein, i.e., the heat sink 8 is circumferentially disposed around the pump 3.

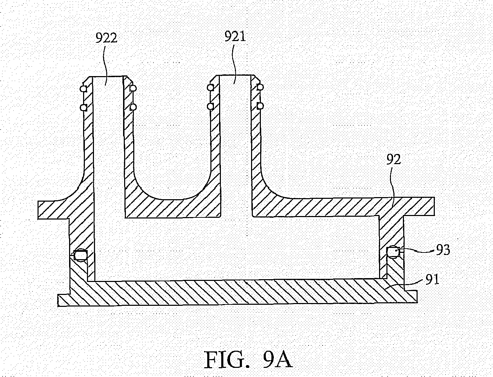

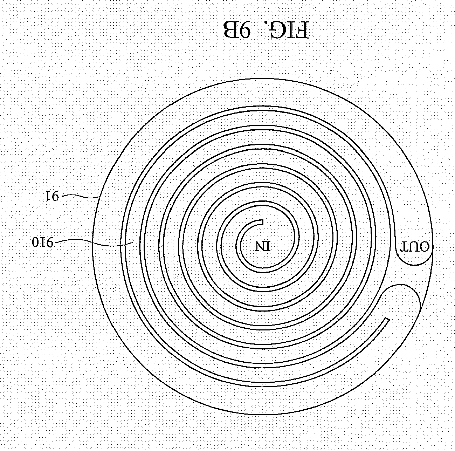

In Figs. 9A and 9B, the conductive seat 9 comprises a chassis 91, a cover 92 and a dissipative passage 910. The dissipative passage 910 has a concentrically vortex structure or an inside-outwardly extending spiral structure. The dissipative passage 910 can be formed on the chassis 91 by milling, or the dissipative passage 910 can be integrally formed on the cover 92 by injection molding. An O-ring 93 is disposed between the chassis 91 and the cover 92. When the working fluid at low temperature enters the dissipative passage 910 via the inlet 921 of the cover 92, the working fluid absorbing heat from the heat source 12 is expelled via the outlet 922 to the inlet 40 of the heat sink 4.

When the working fluid absorbing heat from the CPU 12 at high temperature inflows into the inlet 40 of the pump 3 and outflows from the outlet 41 of the pump 3 by the guide blade 391 of the pump 3, the heated working fluid is transmitted to the heat pipe 83 connected to the outlet 41, and the fins 82 absorb heat from the heated working fluid in the heat pipe 83.

The fan 2 blows the fins 82 and the heat pipe 83 to dissipate heat accumulated thereon to the exterior, reducing the temperature of the working fluid in the heat pipe 83. Thus, the cooled working fluid in the heat pipe 83 is transmitted to a conduit 5, circulating to the dissipative passage 910 of the conductive seat 9 disposed on the CPU 12 to absorb heat therefrom.

The invention provides the fan 2 and the pump 3 actuated by a single motor, to reduce the manufacturing cost, simplify the structure and decrease the occupied space. Further, due to the fan 2 and the pump 3 being integrally formed, the conventional waterproof design between the silicon-steel stator and the magnetic ring can be omitted, while leaving the safe-rotation clearance, to increase performance and efficient of the motor.

While the invention has been described with respect to preferred embodiment, it is to be understood that the invention is not limited thereto, but, on the contrary, is intended to accommodate various modifications and equivalent arrangements included within the spirit and scope of the appended claims.

## Claims

1. A liquid-cooled heat dissipation module, comprising:
a base;
a rotor supported by the base and having a hub;
a first magnetic part disposed on a top of the hub; and
a pump comprising a second magnetic part and a fixed seat, wherein the fixed seat coupled to the base comprises a space to receive the second magnetic part;
when the first magnetic part rotates along with the rotor, a magnetic force is generated between the first and second magnetic parts to rotate the second magnetic part, circulating the working fluid in the pump.

2. The liquid-cooled heat dissipation module as claimed in claim 1, wherein the rotor further comprises a metallic housing, and the first magnetic part is disposed in a space between an inner top surface of the hub and a top surface of the metallic housing.

3. The liquid-cooled heat dissipation module as claimed in claim 1 or 2, wherein the rotor further comprises a metallic housing, and the top of hub comprises an opening to receive the first magnetic part supported by the metallic housing.

4. The liquid-cooled heat dissipation module as claimed in one or more of the claims 1 to 3, further comprises a frame to receive the base and the rotor therein, and the fixed seat is connected to the frame by locking, engaging, riveting, adhesion or ultrasonic fusion.

5. The liquid-cooled heat dissipation module as claimed in one or more of the claims 1 to 4, wherein the pump further comprises a cover connected to the fixed seat to form a space therebetween, and the second magnetic part is disposed in the space between the cover and the fixed seat, and the liquid-cooled heat dissipation module further comprises an O-ring disposed at an intersection between the chassis and the cover.

6. The liquid-cooled heat dissipation module as claimed in one or more of the claims 1 to 5, wherein the pump further comprises a central hole to receive a bearing and a wearing piece, and a shaft of the pump supported by the bearing is fixed on the fixed seat, and the bearing and the shaft of the pump are made of a ceramic material.

7. The liquid-cooled heat dissipation module as claimed in claim 6, wherein the second magnetic part comprises a guide blade and a magnetic ring and the pump further comprises an inlet and an outlet, so that the working fluid inflowing through the inlet passes through the outlet when the guide blade and the magnetic ring are rotated with respect to the shaft of the pump.

8. The liquid-cooled heat dissipation module as claimed in one or more of the claims 1 to 7, wherein the second magnetic part further comprises a magnetic body and a plastic material covering the magnetic body to form a plastic-covered magnetic body, or the second magnetic part comprises a plastic-magnet mixture integrally formed by injection molding.

9. The liquid-cooled heat dissipation module as claimed in one or more of the claims 1 to 8, wherein a clearance is formed between the first magnetic part and the second magnetic part, and an axially or radially magnetic attraction force generated between the first magnetic part and the second magnetic part actuates the pump.

10. The liquid-cooled heat dissipation module as claimed in one or more of the claims 1 to 9 further comprising a heat sink circumferentially disposed around the pump and comprising a central hole to receive the pump therein.

11. The liquid-cooled heat dissipation module as claimed in one or more of the claims 1 to 10 further comprising a conductive seat attached to a heat source to conduct heat generated from the heat source to the pump.

12. The liquid-cooled heat dissipation module as claimed in claim 11, wherein the conductive seat comprises a chassis, a cover and a passage, wherein the passage comprises a concentrically vortex structure or an inside-outwardly extending spiral structure.

13. The liquid-cooled heat dissipation module as claimed in claim 12, wherein the passage on the chassis is formed by milling, or the cover and the passage are integrally formed by injection molding.

14. A liquid-cooled heat dissipation module, comprising:
a base;
a rotor supported by the base and having a shaft extending outwardly from the base at one end thereof;
a first magnetic part disposed on an extruded portion of the shaft; and
a pump comprising a second magnetic part and a fixed seat coupled to the base to form a first space to receive the first magnetic part;
when the first magnetic part rotates along the rotor, a magnetic force is generated between the first and second magnetic parts to rotate the second magnetic part, circulating the working fluid in the pump.

15. The liquid-cooled heat dissipation module as claimed in claim 14, wherein the first magnetic part comprises a magnet-conductive iron sheet and a magnetic ring attached to the magnet-conductive iron sheet, and the liquid-cooled heat dissipation module further comprises a copper sleeve to install the magnet-conductive iron sheet and the magnetic ring on the shaft, so that the magnet-conductive iron sheet and the magnetic ring and the copper sleeve are synchronically rotated by the shaft.

16. The liquid-cooled heat dissipation module as claimed in claim 14 or 15, wherein the second magnetic part comprises a guide blade and a magnetic ring and the pump further comprises an inlet and an outlet so that the working fluid inflowing through the inlet passes through the outlet when the guide blade and the magnetic ring are rotated with respect to the shaft of the pump.

17. The liquid-cooled heat dissipation module as claimed in one or more of the claims 14 to 16, wherein a clearance is formed between the first magnetic part and the second magnetic part, and an axially or radially magnetic attraction force generated between the first magnetic part and the second magnetic part actuates the pump.

18. The liquid-cooled heat dissipation module as claimed in one or more of the claims 14 to 17, wherein the second magnetic part further comprises a magnetic body and a plastic material covering the magnetic body to form a plastic-covered magnetic body, or the second magnetic part comprises a plastic-magnet mixture integrally formed by injection molding.

19. The liquid-cooled heat dissipation module as claimed in one or more of the claims 14 to 18, wherein the pump further comprises a cover connected to the fixed seat to form a second space to receive the second magnetic part, and the cover is connected to the fixed seat by locking, engaging, riveting, adhesion or ultrasonic fusion.

20. The liquid-cooled heat dissipation module as claimed in one or more of the claims 14 to 19, further comprising a heat sink circumferentially disposed around the pump and comprising a central hole to receive the pump therein.

21. A liquid-cooled heat dissipation module, comprising:
a base comprising a recess;
a rotor supported by the base, comprising a first magnetic part; and
a pump comprising a second magnetic part disposed in the recess;
when the first magnetic part of the rotor rotates, a magnetic force is generated to rotate the second magnetic part, circulating the working fluid in the pump.

22. The liquid-cooled heat dissipation module as claimed in claim 21, wherein the pump further comprises a guide blade and the pump further comprises an inlet and an outlet, so that the working fluid inflowing through the inlet passes through the outlet when the guide blade are rotated with respect to the second magnetic part.

23. The liquid-cooled heat dissipation module as claimed in claim 21 or 22, wherein the second magnetic part further comprises a magnetic body and a plastic material covering the magnetic body to form a plastic-covered magnetic body, or the second magnetic part comprises a plastic-magnet mixture integrally formed by injection molding.

24. The liquid-cooled heat dissipation module as claimed in one or more of the claims 21 to 23, wherein the pump further comprises a cover connected to the base by locking, engaging, riveting, adhesion or ultrasonic fusion.

25. The liquid-cooled heat dissipation module as claimed in one or more of the claims 21 to 24 wherein an axially or radially magnetic attraction force is generated between the first magnetic part and the second magnetic part.

26. The liquid-cooled heat dissipation module as claimed in one or more of the claims 21 to 25 further comprising a heat sink circumferentially disposed around the pump and comprising a central hole to receive the pump therein.
